(19) Europäisches Patentamt
European Patent Office
Office européen des brevets

(11) EP 1 298 720 A1

(12) EUROPEAN PATENT APPLICATION

(43) Date of publication:
02.04.2003 Bulletin 2003/14

(51) Int Cl.[7]: H01L 21/68

(21) Application number: 02021664.4

(22) Date of filing: 27.09.2002

(84) Designated Contracting States:
AT BE BG CH CY CZ DE DK EE ES FI FR GB GR IE IT LI LU MC NL PT SE SK TR
Designated Extension States:
AL LT LV MK RO SI

(30) Priority: 28.09.2001 JP 2001301680

(71) Applicant: Nissin Electric Co., Ltd.
Kyoto-shi, Kyoto 615-8686 (JP)

(72) Inventor: Ishida, Shuya,
c/o Nissin Ion Equipment Co., Ltd.
Kyoto-shi, Kyoto 601-8205 (JP)

(74) Representative: Grünecker, Kinkeldey,
Stockmair & Schwanhäusser Anwaltssozietät
Maximilianstrasse 58
80538 München (DE)

# (54) Method and apparatus for holding a substrate

(57) A substrate holding apparatus includes an electrostatic chuck for electrostatically chucking and holding a substrate, an chucking power supply for applying a DC chucking voltage to the electrostatic chuck, a chuck drive device for mechanically driving the electrostatic chuck, and a drive control unit for controlling the chuck drive device by applying command information. The apparatus further includes a chucking control unit which compute the accelerations at each time point that the substrate being held undergoes when the electrostatic chuck is mechanically moved, according to the command information which is applied from the drive control unit to the chuck drive device, computes an chucking force required for holding the substrate at each time point by using the accelerations thus computed, and varies an chucking voltage output from the chucking power supply according to the computed chucking force so that the electrostatic chuck generates the computed chucking force.

FIG. 1

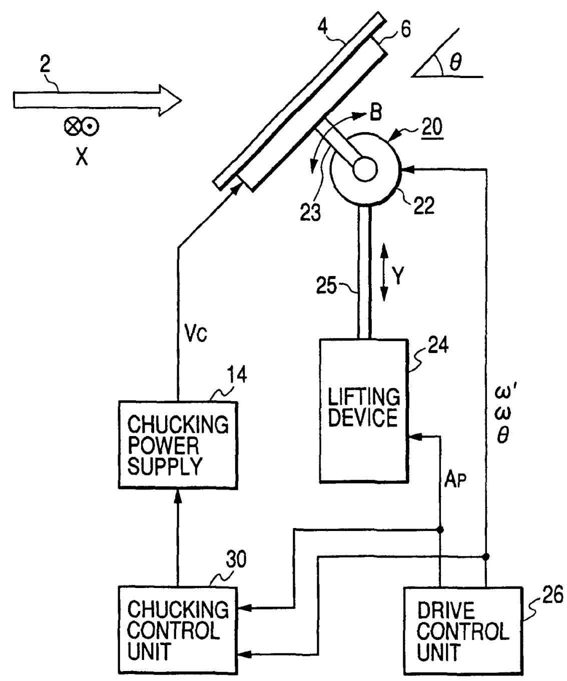


EP 1 298 720 A1

## Description

## Background of the Invention

### Field of the Invention

The present invention relates to a method and apparatus for holding a substrate, the apparatus comprising an electrostatic chuck for electrostatically chucking and holding a substrate to be processed. More particularly, the present invention relates to a method and apparatus for holding a substrate which are capable of producing a sufficiently high chucking force during the substrate chucking operation, and making it easy to separate the substrate after the chucking operation ends. For example, the substrate holding apparatus is used for an ion implanter, ion doping apparatus, ion beam etching apparatus, plasma CVD apparatus, thin film forming apparatus and the like.

### Description of the Related Art

A related-art substrate holding apparatus of this type is shown in Fig. 12. The substrate holding apparatus includes an electrostatic chuck 6 of the bipolar type, and a DC power supply 14 of the bipolar output type. The electrostatic chuck 6 electrostatically chucks a substrate 4 (e.g., a semiconductor wafer). The DC power supply 14 applies DC chucking voltages Vc whose polarities are opposite to each other and values are equal to two electrodes 10 and 12 of the electrostatic chuck 6.

In this example, the electrostatic chuck 6 is constructed such that, for example, two semicircular electrodes 10 and 12 are buried in a surface region of an insulating member 8 made of ceramics, e.g., alumina, while being oppositely arrayed so as to form a circle.

In this example, the DC power supply 14 includes a positive power supply 16 of the output voltage variable type and a negative power supply 18 of the output voltage variable type. The positive power supply 16 outputs a positive chucking voltage Vc (+Vc). The negative power supply 18 outputs a negative chucking voltage Vc (-Vc). In the specification, the positive or negative chucking voltage will be referred simply to as a chucking voltage Vc where there is no need of taking the polarity into consideration. The same thing is correspondingly applied to the drawings.

When the chucking voltage Vc is applied from the DC power supply 14 to the electrostatic chuck 6, positive and negative electric charges are accumulated between the substrate 4 and the electrodes 10 and 12. The substrate 4 is chucked to and held with the electrostatic chuck 6 by an electrostatic force acting between the substrate 4 and the electrodes 10 and 12. In this state, ion beams 2, for example, are irradiated onto the substrate 4, whereby a desired process, e.g., ion implantation, may be carried out.

In the electrostatic chuck 6 thus constructed, a residual chucking force is present after the chucking voltage Vc is turned off. Accordingly, it is difficult to separate the substrate 4 from the electrostatic chuck 6.

This residual chucking force depends on an application amount of chucking voltage applied to the electrostatic chuck 6. Exactly, as the application amount of the chucking voltage becomes larger, the amount of charge left in the electrostatic chuck 6 is larger. As a result, the residual chucking force becomes large. Generally, the application amount Q of the chucking voltage is the integration of the chucking voltage Vc over an chucking time Tc for which the substrate 4 is chucked by the electrostatic chuck 6, and mathematically given by the following expression.

[Formula 1]

$$Q = \int_0^{Tc} Vc\, dt$$

A technique to reduce the application amount Q of chucking voltage is disclosed in Japanese Patent No. 2,574,066. In the patent, a necessary, first chucking voltage Vc, relatively large, is applied to the electrostatic chuck at the start of chucking operation, and then a second chucking voltage Vc, relatively small, for chucking and holding the substrate when the substrate is processed, is applied to the electrostatic chuck (this technique will be referred to as prior art).

The inventor of the present invention proposed another technique (referred to as related art) to further reduce the application amount Q of the chucking voltage. In the technique, the chucking voltage Vc is exponentially decreased irrespective of the presence of the substrate processing (U.S. Application No. , titled METHOD AND APPARATUS FOR CHUCKING A SUBSTRATE, and filed on August 7, 2002 which is claimed with the benefit of the filling date of Japanese Patent Application No. 2001-245227 filed on August 13, 2001).

It is frequent that the electrostatic chuck 6 (and the substrate 4 held by the electrostatic chuck) is mechanically driven when the substrate 4 is processed (during the processing of the substrate 4 and before and after the processing).

With substrate process diversification and progress, a motion of the electrostatic chuck 6 is complicated. A measure that the prior art and the related art can take for the complicated motion is to merely apply to the electrostatic chuck 6 such an chucking voltage Vc as to produce an chucking force as is obtained as the greatest common divisor (GCD) for the chucking forces necessary for the entire period of holding the substrate. In other words, a larger chucking voltage Vc, which is necessary at some time points during the period of holding the substrate, is applied to the electrostatic chuck 6 at other time points at which such a large chucking force is not required. Therefore, there is a limit in reducing the application amount Q of chucking voltage. This is more remarkable, particularly in the prior art.

This will be described in detail with reference to Figs. 13 and 10.

In addition to the electrostatic chuck 6 and the chucking power supply 14, the substrate holding device of Fig. 13 includes a chuck drive device 20 for mechanically driving the electrostatic chuck 6, and a drive control unit 26 for controlling a motion of the chuck drive device 20 by applying command information to the chuck drive device 20. The electrostatic chuck 6 and the chucking power supply 14 are illustrated in a simple form, the details of them are as shown in Fig. 12 (the same thing is true for the illustration of Figs. 1, 11 and others).

The chuck drive device 20 includes a rotation device 22 and an lifting device 24. The rotation device 22, in this instance, rotates the electrostatic chuck 6 in arrow directions B via a coupling member 23 to vary a rise angle θ of the electrostatic chuck 6 and substrate 4 (e.g., $0° \leqq \theta \leqq 90°$). The lifting device 24 moves up and down in Y directions (e.g., vertical directions) via a shaft 25. The rotation device 22 and the lifting device 24 include electric motors in this instance, and those motors are controlled by a drive control unit 26.

In an ion implanter of the hybrid scan type, for example, ion beams 2, which are scanned in an X direction (e.g., horizontal direction) substantially orthogonal to the Y direction, are irradiated on the substrate 4 held by the substrate holding device, whereby ions are uniformly implanted into the surface of the substrate 4.

Operation of the ion implanter will be described with reference to Figs. 10 and 13. It is assumed that the electrostatic chuck 6 is horizontally postured (i.e., $\theta = 0°$). In this state, the substrate 4 is set on the electrostatic chuck by an arm etc. (not shown) (at a time point t2 in Fig. 10. The time point is indicated simply, e.g., t = 2). Substantially simultaneously with the substrate setting, a chucking voltage Vc is applied to the electrostatic chuck 6. The voltage application continues to a time point near t = 21, just before the substrate separates.

Thereafter, the electrostatic chuck 6 is made to stand up (to vertically be raised so as to increase the rise angle θ) (t = 4 to t = 8). Subsequently, the ascending operation of the electrostatic chuck 6 starts (t = 9); the electrostatic chuck is moved at a constant speed (t = 10), the ascending operation of it ends ( t = 11); the descending operation starts of it starts (t = 12); the electrostatic chuck is moved at a constant speed (t = 13); and the descending operation of it ends ( t = 14). During the constant speed movement of the electrostatic chuck, the ion beam 2 is radiated on the substrate 4 to thereby effect an ion implantation process. The cycle of ascending and descending operations of the electrostatic chuck is repeated a predetermined number of times, usually depending on implantation conditions.

Upon completion of implanting a predetermined dosage of ions, the electrostatic chuck 6 is laid down (so as to set up the rise angle $\theta = 0°$) (t = 15 to t = 19), and then the chucking voltage Vc is turned off (t = 20 or t = 21) to separate the substrate 4 from the electrostatic chuck 6 (t = 22).

In connection with such a motion of the electrostatic chuck 6, an chucking force at each time point, which is required when the substrate 4 is chucked to and held by the electrostatic chuck 6 are depicted as bars "j" and "k" in Fig. 10. The bar "j" indicates a necessary chucking force component as viewed from the acceleration (an acceleration $A_H$ to be described later) of the sideways slipping direction acting on the substrate 4. The bar "k" is a necessary chucking force component as viewed from the acceleration (an acceleration $A_V$ to be described later) of the separating direction acting on the substrate. The ways of computing those accelerations and the chucking forces will be described in detail later.

For the motion of the electrostatic chuck 6, the prior art applies the chucking voltage Vc as represented by a polygonal line "g" in Fig. 10 to the electrostatic chuck, and the related art applies the chucking voltage Vc as represented by a polygonal line "h" to the electrostatic chuck. In either technique, an excessive chucking voltage Vc is applied to the electrostatic chuck at other time points than the time points (t = 9 to t = 14) at which a large chucking force must be applied. In the prior art, this is remarkable in particular. Accordingly, the application amount Q of the chucking voltage mentioned above is excessively large. The presence of the excessive application amount Q of the chucking voltage hinders the reduction of the residual charge in and residual chucking force by the electrostatic chuck 6.

## Summary of the Invention

Accordingly, an object of the present invention is to provide a method and apparatus which enable the electrostatic chuck to reliably chuck and hold the substrate even when the electrostatic chuck is mechanically moved, and effectively reduce an application amount of the chucking voltage applied to the electrostatic chuck.

Amethod for holding a substrate of the present invention comprises computing an chucking force required for holding the substrate at each time point during a period of holding the substrate according to one or more accelerations that the substrate being held undergoes when the electrostatic chuck is mechanically moved, and varying the chucking voltage output from the chucking power supply according to the computed chucking force so that the electrostatic chuck generates the computed chucking force.

An apparatus for holding a substrate includes a chucking control unit which 1) computes an chucking force required for holding the substrate at each time point during a period of holding the substrate according to one or more accelerations that the substrate being held undergoes when the electrostatic chuck is mechanically moved, and 2) varies the chucking voltage output from the chucking power supply according to the computed chucking force so that the electrostatic chuck generates the computed chucking force.

In the invention defined above, at each time point during the period of holding the substrate, the chucking voltage is varied so that the electrostatic chuck produces an chucking force required at that time. Accordingly, there is no chance that an excessive chucking voltage is applied to the electrostatic chuck 6. Accordingly, even if the electrostatic chuck is mechanically moved, the substrate holding apparatus is capable of reliably chucking and holding the substrate. Additionally, the excessive application amount of chucking voltage is minimized, resulting in effective reduction of the application amount of chucking force applied to the electrostatic chuck.

As a result, the residual charge in the electrostatic chuck is effectively reduced, and hence the residual chucking force is effectively reduced. The separation of the substrate 4 from the electrostatic chuck is easier.

Further, the invention may be implemented into a method which comprises computing the one or more accelerations that the substrate being held undergoes when the electrostatic chuck is mechanically moved, at each time point during the period of holding the substrate, according to command information which is applied from the drive control unit to the chuck drive device; computing an chucking force required for holding the substrate at each time point during the period of holding the substrate according to using the computed accelerations; and varying the chucking voltage output from the chucking power supply according to the computed chucking force so that the electrostatic chuck generates the computed chucking force.

## Brief Description of the Drawings

Fig. 1 is a diagram schematically showing a substrate holding apparatus for executing a substrate holding method, which is constructed according to the invention;
Fig. 2 is a block diagram showing an arrangement of a chucking control unit in the Fig. 1 apparatus;
Fig. 3 is a diagram for explaining a force acting on the substrate held by the electrostatic chuck in the Fig. 1 apparatus;
Fig. 4 is a diagram for explaining a force acting on the substrate held by the electrostatic chuck in the Fig. 1 apparatus;
Fig. 5 is a diagram for explaining a force acting on the substrate held by the electrostatic chuck in the Fig. 1 apparatus;
Fig. 6 is a diagram for explaining a force acting on the substrate held by the electrostatic chuck in the Fig. 1 apparatus;
Fig. 7 is a diagram for explaining a force acting on the substrate held by the electrostatic chuck in the Fig. 1 apparatus;
Fig. 8 is a diagram for explaining a force acting on the substrate held by the electrostatic chuck in the Fig. 1 apparatus;
Fig. 9 is a graph showing a relationship among chucking voltage, chucking time and chucking force in the Fig. 1 apparatus;
Fig. 10 is a graph showing contents of an operation of the substrate holding apparatus of Fig. 1, and an example of chucking forces and chucking voltage at every time points;
Fig. 11 is a diagram schematically showing another substrate holding apparatus for executing a substrate holding method, which is constructed according to the invention;
Fig. 12 is a diagram showing a basic construction of the substrate holding apparatus; and
Fig. 13 is a diagram showing a prior-art substrate holding apparatus.

## Detailed Description of the Invention

Fig. 1 is a diagram schematically showing a substrate holding apparatus for executing a substrate holding method, which is constructed according to the invention. In the figure, like or equivalent portions are designated by like reference numerals used in the prior art described referring to Figs. 12 and 13. Description will be given placing emphasis on the difference of the embodiment from the prior-art apparatus.

The substrate holding apparatus includes a electrostatic chuck 6 (as mentioned above), a chucking.power supply 14, a chuck drive device 20 and a drive control device 26, and further includes a chucking control device 30. The chucking control device 30 controls a chucking voltage $V_c$ output from the chucking power supply 14 (viz., it is applied to the electrostatic chuck 6). The chucking control device 30 receives command information which is output from drive control device 26 to the chuck drive device 20.

The chucking control device 30 includes an acceleration computing unit 32, an chucking force computing unit 34, a chucking voltage computing unit 36 and a power supply control unit 38. The acceleration computing unit 32 computes accelerations, which are generated in the substrate 4 by a mechanical motion of the electrostatic chuck 6, at respective time points during a time period of holding the substrate (e.g., time points t = 2 to t = 22). The computation is performed according to the command information which is applied from the drive control unit 26 to the chuck drive device 20. The chucking force computing unit 34 computes an chucking forces at the respective time points, which are necessary for holding the substrate 4 while resisting the accelerations computed by the acceleration computing unit 32. The chucking voltage computing unit 36 computes a chucking voltage $V_c$ at each time point, which is necessary for. the electrostatic chuck 6 to generate the chucking force computed by the chucking force computing unit 34. The power supply control unit 38 causes the chucking power supply 14 to generate the chucking voltage Vc computed by the chucking voltage computing unit 36. Those unit 32, 34, 36 and 38, i.e., the chucking control device 30, may be realized by using a computer, for example.

Such an operation by the chucking control unit 30 that it computes a necessary chucking force according to the command information, which is issued from the drive control unit 26 to the chuck drive device 20, and controls the chucking voltage Vc, will be described in detail.

Accelerations which are generated in the electrostatic chuck and the substrate 4 held by it by motions of the electrostatic chuck 6 as indicated by the arrow directions B and Y, are categorized into two types. See Fig. 3.

a) an acceleration $A_H$ of such a direction as to cause the substrate 4 to slip sideways on the electrostatic chuck 6.
b) an acceleration $A_V$ of such a direction as to vertically separate the substrate 4 from the electrostatic chuck 6.

The acceleration $A_H$ is generated in a case where the electrostatic chuck 6 and the substrate 4 are vertically raised (viz., the substrate 4 slips and drops by gravity), a case where the electrostatic chuck 6 and the substrate 4 are further accelerated in the vertical direction (Y direction), or a case where a centrifugal force is generated when the electrostatic chuck 6 and the substrate 4 are rotationally moved in the direction of the arrow B.

The acceleration $A_V$ is generated in a case where the electrostatic chuck 6 and the substrate 4 are accelerated or decelerated when those are rotationally moved in the direction of the arrow B, a case where the electrostatic chuck 6 and the substrate 4 are decelerated in the upward direction (e.g., decelerated during their ascending movement) in a state that those is raised at a rise angle θ ($0° < \theta < 90°$), or a case where the electrostatic chuck 6 and the substrate 4 are accelerated in the downward direction (e.g., accelerated during their descending movement).

Therefore, if one knows the accelerations $A_H$ and Av generated in the electrostatic chuck 6 and the substrate 4, it is possible to obtain an chucking force at which its chucking state is maintained while resisting the acceleration. Further, the chucking voltage $V_C$ necessary for generating the chucking force is computed, thereby effecting an appropriate control.

The accelerations $A_H$ and $A_V$ that the substrate 4 undergoes are computed for those cases (1) and (2), respectively. The computation is carried out using the following command values: acceleration command value $A_P$[m/s$^2$] in the vertical direction (direction Y) issued from the drive control device 26 to the lifting device 24, angular acceleration command value ω' [rad/s$^2$] in the rotational direction (direction of the arrow B) issued from the drive control device 26 to the rotation device 22, angular velocity command value ω[rad/s], and rise-angle command value θ[rad].

(1) Reference is made to Figs. 3 and 4. Under conditions that the acceleration of gravity is G[m/s$^2$], and the electrostatic chuck 6 and the substrate 4 are vertically moved up and down, the accelerations $A_H$ and $A_V$ are given by the following equations. In Fig. 3, the positive directions of the accelerations $A_P$, $A_H$ and $A_V$ are indicated by sign "+", and the negative positions of them, sign "-". The same thing is true for other figures of drawing.

[Formula 2]

$$A_H = (A_P - G)\sin\theta$$

$$A_V = (A_P - G)\cos\theta$$

(2) With regard to the acceleration of the electrostatic chuck 6 and the substrate 4 when those are rotated, follows. The respective parts of the substrate 4 are different in position with respect to the center of rotation (viz., in distance measured from the center of rotation). Therefore, the accelerations are different in the respective parts of the substrate 4. However, of those accelerations, the largest one is handled as a representative acceleration, and what a designer has to do is to compute an chucking force per unit area which is large enough to endure the maximum acceleration.

To compute the accelerations $A_H$ and $A_V$ of the substrate 4, it is assumed that a mechanism is defined such that as shown in Fig. 5, a line "d" connecting the center "a" of the substrate 4 and the center "b" of the rotation of the substrate 4 and the like which is caused by the rotation device 22, extends from the substrate center "a" in the direction perpendicular to the substrate surface. The respective points, in the substrate surface, on a line "e" which is perpendicular to a tangential line to a locus developed at the substrate center "a" when the substrate center "a" is rotated, are equally distanced from the rotational center "b". Therefore, the accelerations on the line "e" are all equal in value.

The respective points, in the substrate surface, on a tangential line "f" to a locus developed at the substrate center "a" when the substrate center "a" is rotated, are unequally distanced from the rotational center "b". Therefore, the accelerations on the line "f" at the respective points are different from one another.

Therefore, to obtain the largest acceleration of those accelerations at the respective points on the substrate 4, it is satisfactory for a designer to take into consideration only the accelerations at the respective points on the line "f", as mentioned above.

To express the respective points on the line "f", as shown in Fig. 6, a distance (rotational radius) between a point "c" on the line "f" and the rotational center "b" is given by

$$\sqrt{(L^2 + R^2)}$$

where L [m] : distance between the point "c" on the line "f" and the substrate center "a", and

R [m] : distance between the substrate center "a" and the rotational center "b". See also Fig. 7.

As shown in Fig. 7, the point "c" on the line "f" is rotated by the rotation device 22 according to an angular acceleration command value ω' and an angular velocity command value ω, with a rotational radius of $\sqrt{(L^2 + R^2)}$. With the rotation, the rise angle θ also varies. An acceleration $A_T$[m/s$^2$] of a direction in which a tangential line for the rotation extends and an acceleration $A_C$[m/s$^1$] generated by a centrifugal force by the rotation, which are generated in point "c" on the substrate, are expressed by

[Formula 3]

$$A_T = \sqrt{(L^2 + R^2)} \cdot \omega'$$

$$A_C = \sqrt{(L^2 + R^2)} \cdot \omega^2$$

Accordingly, an acceleration that the point "c" undergoes maybe expressed by the following equations for the accelerations $A_H$ and $A_V$, when the gravity acceleration G is taken into consideration,

[Formula 4]

$$A_H = -A_T \cdot \cos\theta + A_C \cdot \sin\theta - G \cdot \sin\theta$$

$$= -\sqrt{(L^2 + R^2)} \cdot \omega' \cdot \cos\theta + \sqrt{(L^2 + R^2)} \cdot \omega^2 \cdot \sin\theta - G \cdot \sin\theta$$

$$A_V = A_T \cdot \sin\theta + A_C \cdot \cos\theta - G \cdot \mathrm{COS}\theta$$

$$= \sqrt{(L^2 + R^2)} \cdot \omega' \cdot \sin\theta + \sqrt{(L^2 + R^2)} \cdot \omega^2 \cdot \cos\theta - G \cdot \cos\theta$$

In computing the maximum values $A_{HM}$ and $A_{VM}$ of the accelerations $A_H$ and $A_V$ in the substrate surface at the time points (for example, time points t = 2 to t = 22 in Fig. 10. The same shall apply hereinafter. The operations at the respective time points are already described. ) during the period of holding the substrate, distance R in the formula 4 is a fixed value determined by a structure of the apparatus (specifically, the length of the coupling member 23 or the like) . The an angular acceleration command value ω', an angular velocity command value ω, and the rise angle θ also take fixed values which are transferred from the drive control unit 26 to the chuck drive device 20 every time point.

Accordingly, the accelerations $A_H$ and $A_V$ at the respective time points during the period of holding the substrate are computed by varying the length L within a range of $-r \leq L \leq r$ (r is the radius of the substrate 4). Of those computed accelerations $A_H$ and $A_V$, the accelerations largest in value are used as the maximum values $A_{HM}$ and $A_{VM}$. This is mathematically expressed by

[Formula 5]

$$A_{HM} = \max(-A_T \cdot \cos\theta + A_C \cdot \sin\theta - G \cdot \sin\theta)$$

$$= \max\{-\sqrt{}(L^2 + R^2) \cdot \omega' \cdot \cos\theta + \sqrt{}(L^2 + R^2) \cdot \omega^2 \cdot \sin\theta - G \cdot \sin\theta)$$

$$A_{VM} = \max(A_T \cdot \sin\theta + A_C \cdot \cos\theta - G \cdot \cos\theta)$$

$$= \max\{\sqrt{}(L^2 + R^2) \cdot \omega' \cdot \sin\theta + \sqrt{}(L^2 + R^2) \cdot \omega^2 \cdot \cos\theta - G \cdot \cos\theta)$$

For each of two cases, a first case where the electrostatic chuck 6 and the substrate 4 are moved in the vertical direction, and a second case where the electrostatic chuck 6 and the substrate 4 are rotated, the acceleration $A_H$ of such a direction as to cause the substrate 4 to slip sideways on the electrostatic chuck 6 (in the second case, the maximum value $A_{HM}$ in the substrate surface) is computed at every time point by using the formulas 2 and 5. Further, for each of cases, the acceleration $A_V$ of such a direction as to separate the substrate 4 off the electrostatic chuck 6 (in the second case, the maximum value $A_{HM}$ in the substrate surface) is computed at every time point by using the formulas 2 and 5. In the instance of Fig. 2, the acceleration computing unit 32 computes those accelerations.

Subsequently, an chucking force per unit area N[kg · m/ (s$^2$ · m$^2$)] to be produced by the electrostatic chuck 6, required when the electrostatic chuck 6 holds the substrate 4 while resisting the accelerations $A_H$ and $A_V$ is computed using the accelerations $A_H$ and $A_V$ thus computed. The computation is performed by using mass M [kg · cm$^2$] per unit area of the substrate 4 and in the following ways (3) and (4).

(3) In the direction in which the substrate 4 slips sideways from the electrostatic chuck 6, a force that the substrate 4 receives at a part of a unit area is $M \cdot A_H$ [kg · m/(s$^2$ · m$^2$) ] when the substrate is accelerated or decelerated. A force resisting the force acting on the unit area is a static friction force generated when the chucking force N presses the substrate 4 against the electrostatic chuck 6. Therefore, it is satisfactory to generate such an chucking force N as to satisfy the following expression, while referring to Fig. 8. In this case, μ is a maximum friction coefficient between the substrate 4 and the electrostatic chuck 6.

[Formula 6]

$$\mu \cdot N \geq M \cdot A_H$$

Rearranging this expression, then we have

$$N \geq M \cdot A_H/\mu$$

(4) In the direction in which the substrate 4 is separated from the electrostatic chuck 6, the generated chucking force per se resists the force to separate the substrate 4. Accordingly, it is satisfactory to generate such an chucking force N as to satisfy the following relation, while referring to Fig. 8.

[Formula 7]

$$N \geq M \cdot A_V$$

Accordingly, it is satisfactory to select such an chucking force to satisfy both formulas 6 and 7 (i.e., the larger of the chucking forces N computed by using the formula 6 and 7) for the chucking force N that the electrostatic chuck 6 actually generates. Such an chucking force N is computed at every time point during the time period of holding the substrate. When such an chucking force N is used, the electrostatic chuck 6 reliably holds the substrate 4 while resisting the acceleration of the sideways slipping direction and the acceleration of the separation direction, and a chance of generating an excessive chucking force is eliminated. The computation, in the Fig. 2 instance, is performed by the chucking force computing unit 34.

Simple examples of the chucking force N follow. In a first example where the electrostatic chuck 6 and the substrate 4 are at a standstill in a horizontal state, the chucking force N may be extremely small, nearly 0 (zero) . In another example where the electrostatic chuck 6 and the substrate 4 is postured in a vertical state (rise angle = 90°), the acceleration of the sideways slipping direction is problematic, as seen from the formula 2. Also when the substrate 4 undergoes an acceleration of the direction opposite to that of the gravity force (e.g., it is decelerated when it is ascending or it is accelerated when it is descending. See t = 11 or t = 12 in Fig. 10), the acceleration is canceled by the acceleration of gravity. Therefore, the chucking force N may be extremely small.

Thereafter, by using the thus computed chucking force N at each time point, the chucking voltage Vc at each time point, which is necessary for the electrostatic chuck 6 to generate such the chucking force N, is computed. To this end, a relationship among the chucking force N, chucking voltage Vc and chucking time Tc of the electrostatic chuck 6 as shown in Fig. 9, for example, is obtained in advance. Then, a chucking voltage Vc required for a necessary chucking force N is selected from the relationship. More specifically, the Fig. 9 relationship is stored in the form of a table in the chucking control unit 30. The chucking time Tc and the chucking force N at each time point during the period of holding the substrate are used as parameters, and the chucking voltage Vc corresponding to them is selected. If necessary, the resultant may be interpolated. The computation, in the Fig. 2 instance, is performed by the chucking voltage computing unit 36.

The unit of the chucking force N in Fig. 9 is [$gw/cm^2$], and it may be converted into the unit [$kg \cdot m/(s^2 \cdot m^2)$] of the chucking force N already described and vice versa, by using the following equation.

[Formula 8]

$$1[gw/cm^2] = 9.8 \times 10^{-3}\ [kg \cdot m/(s^2 \cdot m^2)]$$

The chucking power supply 14 is controlled so as to generate the thus computed chucking voltage Vc at each time point, and the chucking voltage Vc is applied to the electrostatic chuck 6. Such a control, in the Fig. 2 instance, is carried out by the power supply control unit 38.

In Fig. 10, the values of the thus computed chucking force N at time points are represented by a polygonal line "m", and the values of the chucking voltage Vc generated based the chucking force N is represented by a polygonal line "i". The chucking force varies also with the chucking time Tc. Accordingly, the line "m" of the necessary chucking force N resembles the line "i" of the chucking voltage Vc in shape, but a complete proportional relation is not present between them. A necessary chucking force component "j" of the sideways slipping direction for the substrate 4 as viewed from the acceleration $A_H$, and a necessary chucking force component "k" of the separating direction for the substrate as viewed from the acceleration $A_V$ are also plotted in pair at time points in the graph of Fig. 10. Of the paired chucking force components, the larger one is selected, and those selected larger ones at the respective time points are connected by segmental lines to form the polygonal line "m" of the necessary chucking force N.

As seen from the comparison of a line "g" (prior art), line "h" (related art) and the line "i" (embodiment of the invention), the time integration value of the chucking voltage Vc in the embodiment, i.e., the application amount Q of the chucking voltage already described, is considerably smaller than that in the prior art and related art.

As described above, in the embodiment, at each time point during the period of holding the substrate, the chucking voltage Vc is varied so that the electrostatic chuck 6 produces an chucking force N required at that time. Accordingly, there is no chance that an excessive chucking voltage Vc is applied to the electrostatic chuck 6. Accordingly, even if the electrostatic chuck 6 is mechanically moved, the substrate holding apparatus is capable of reliably chucking and holding the substrate 4. Additionally, the excessive application amount of chucking voltage is minimized, resulting in effective reduction of the application amount Q of chucking force applied to the electrostatic chuck 6. As a result, the residual charge in the electrostatic chuck 6 is effectively reduced, and hence the residual chucking force is effectively reduced. The separation of the substrate 4 from the electrostatic chuck 6 is easier.

The accelerations at each time point that the substrate 4 being held undergoes when the electrostatic chuck 6 is mechanically moved, viz., the acceleration $A_H$ of the sideways slipping direction and the acceleration $A_V$ of the separating direction, are computed according to the command information issued from the drive control unit 26, in the embodiment mentioned above. In alternative, an acceleration sensor 40 is attached to the electrostatic chuck 6 as shown in Fig. 11. The accelerations $A_H$ and $A_V$ are sensed by the acceleration sensor 40 at respective time points. In this case, the chucking control unit 30 computes the chucking force N required for holding the substrate at respective time points, by using the sensed accelerations $A_H$ and $A_V$ as in the manner already described. Further, the chucking control unit 30 varies the chucking voltage Vc output from the chucking power supply 14 in accordance with the computed chucking force N so that the electrostatic chuck 6 produces the chucking force N.

It should be understood that the invention is not limited to the electrostatic chuck 6 of the bipolar type as mentioned above, but may be applied to an electrostatic chuck of the unipolar type, which has a single electrode. In the case, the DC power supply 14 may be of the unipolar type which outputs positive or negative chucking voltage Vc.

As seen from the foregoing description, in the embodiment, at each time point during the period of holding the substrate, the chucking voltage is varied so that the electrostatic chuck produces an chucking force required at that time. Accordingly, there is no chance that an excessive chucking voltage is applied to the electrostatic chuck 6. Accordingly, even if the electrostatic chuck is mechanically moved, the substrate holding apparatus is capable of reliably chucking and holding the substrate. Additionally, the excessive application amount of chucking voltage is minimized, resulting in effective reduction of the application amount of chucking force applied to the electrostatic chuck. As a result, the residual charge in the electrostatic chuck is effectively reduced, and hence the residual chucking force is effectively reduced. The separation of the substrate 4 from the electrostatic chuck is easier.

## Claims

**1.** A method for holding a substrate in use for a substrate holding apparatus having an electrostatic chuck for electrostatically chucking and holding the substrate, and an chucking power supply for applying a DC chucking voltage to said electrostatic chuck, said method comprising:

computing an chucking force required for holding said substrate at each time point during a period of holding the substrate, according to one or more accelerations that said substrate being held undergoes when said electrostatic chuck is mechanically moved; and
varying the chucking voltage output from said chucking power supply according to said computed chucking force so that said electrostatic chuck generates said computed chucking force.

**2.** The method for holding a substrate according to claim 1, wherein the substrate holding apparatus further has a chuck drive device for mechanically driving said electrostatic chuck, and a drive control unit for controlling a motion of said chuck drive device by applying command information to said chuck drive device, wherein said method further comprises:

computing the one or more accelerations that said substrate being held undergoes when said electrostatic chuck is mechanically moved at each time point during the period of holding the substrate, according to the command information which is applied from said drive control unit to said chuck drive device,

wherein said chucking force computing step computes the chucking force required for holding said substrate at each time point during the period of holding the substrate according to the one ore more accelerations computed by said acceleration computing step.

**3.** The method for holding a substrate according to claim 2, wherein said chucking fore computing steps computes the chucking force required for holding said substrate while resisting said one ore more accelerations computed by said acceleration computing step, at each time point during the period of holding the substrate, and wherein said chucking voltage varying step includes: computing a chucking voltage which is required when said electrostatic chuck generates said chucking force computed by said chucking voltage computing step, at each time point during the period of holding the substrate; and controlling said chucking power supply to generate said chucking voltage computed by said chucking voltage computing step.

**4.** The method for holding a substrate according to claim 1, further comprises:

sensing the one ore more accelerations that said substrate being held undergoes when said electrostatic chuck is mechanically moved at each time point during the period of holding the substrate,

wherein said chucking force computing step computes the chucking force required for holding said substrate at each time point during the period of holding the substrate according to the one ore more accelerations sensed by said acceleration sensing step.

**5.** An apparatus for holding a substrate, comprising:

an electrostatic chuck for electrostatically chucking and holding the substrate;
an chucking power supply for applying a DC chucking voltage to said electrostatic chuck; and
a chucking control unit for computing an chucking force required for holding said substrate at each time point during a period of holding the substrate, according to one or more accelerations that said substrate being held undergoes when said electrostatic chuck is mechanically moved, and varying the chucking voltage output from said chucking power supply according to said computed chucking force so that said electrostatic chuck generates said computed chucking force.

**6.** The apparatus for holding a substrate according to claim 5, further comprising:

a chuck drive device for mechanically driving said electrostatic chuck; and
a drive control unit for controlling a motion of said chuck drive device by applying command information to said chuck drive device,

wherein said chucking control unit computes the one or more accelerations that said substrate being held undergoes when said electrostatic chuck is mechanically moved, at each time point during the period of holding the substrate, according to the command information which is applied from said drive control unit to said chuck drive device, and computes the chucking force required for holding said substrate at each time point during the period of holding the substrate according to the computed one or more accelerations..

**7.** The apparatus for holding a substrate according to claim 6, wherein said chucking control unit includes:

an acceleration computing unit for computing the one or more accelerations that said substrate being held undergoes when said electrostatic chuck is mechanically moved, at each time point during the period of holding the substrate, according to the command information which is applied from said drive control unit to said chuck drive device;
a chucking force computing unit for computing the chucking force required for holding said substrate while resisting said one ore more accelerations computed by said acceleration computing unit, at each time point during the period of holding the substrate;
a chucking voltage computing unit for computing a chucking voltage which is required when said electrostatic chuck generates said chucking force computed by said chucking voltage computing unit, at each time point during the period of holding the substrate; and
a power supply control unit for controlling said chucking power supply to generate said chucking voltage computed by said chucking voltage computing unit..

**8.** The apparatus for holding a substrate according to claim 5, further comprising:

an acceleration sensor for sensing the one ore more accelerations that said substrate being held undergoes when said electrostatic chuck is mechanically moved, at each time point during the period of holding the substrate,

wherein said chucking control unit computes the chucking force required for holding said substrate at each time point during the period of holding the substrate according to the sensed one or more accelerations.

FIG. 1

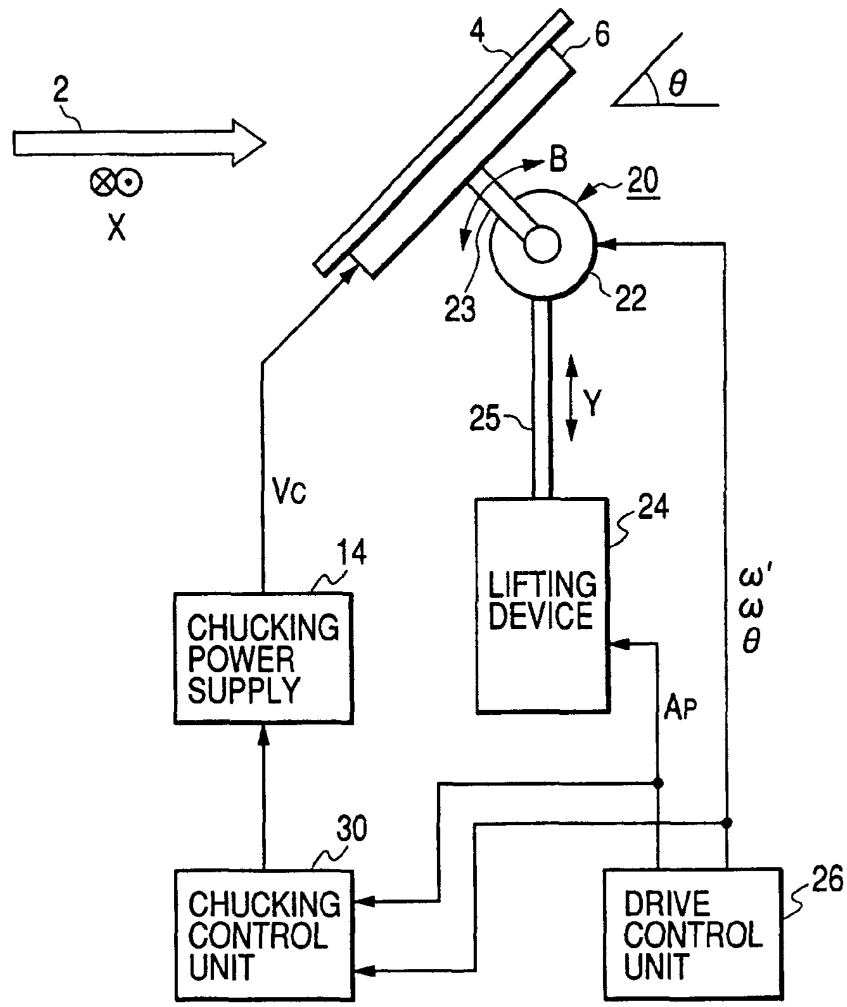
2
X
4
6
θ
B
20
22
23
25
Y
24
LIFTING DEVICE
Vc
14
CHUCKING POWER SUPPLY
ω'
ω
θ
Ap
30
CHUCKING CONTROL UNIT
DRIVE CONTROL UNIT
26

FIG. 2

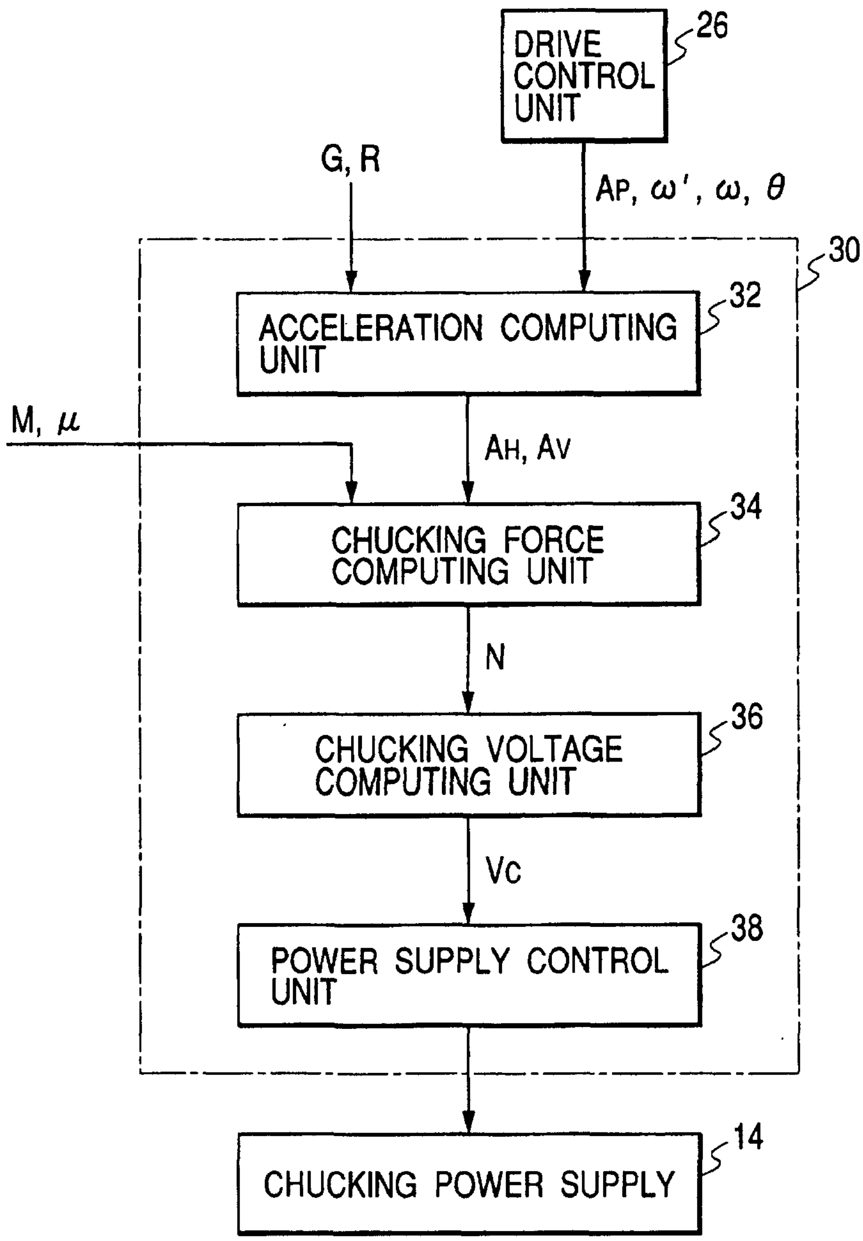
DRIVE CONTROL UNIT
26
G, R
AP, ω', ω, θ
30
ACCELERATION COMPUTING UNIT
32
M, μ
AH, AV
CHUCKING FORCE COMPUTING UNIT
34
N
CHUCKING VOLTAGE COMPUTING UNIT
36
Vc
POWER SUPPLY CONTROL UNIT
38
CHUCKING POWER SUPPLY
14

FIG. 3

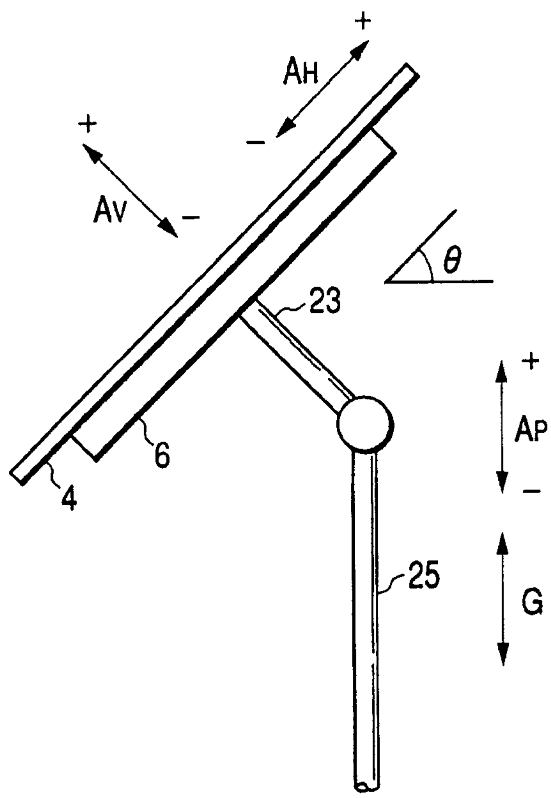


FIG. 4

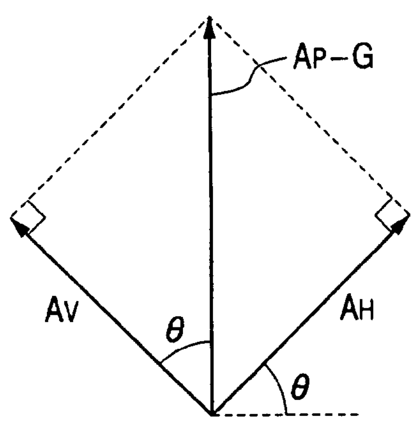

FIG. 5

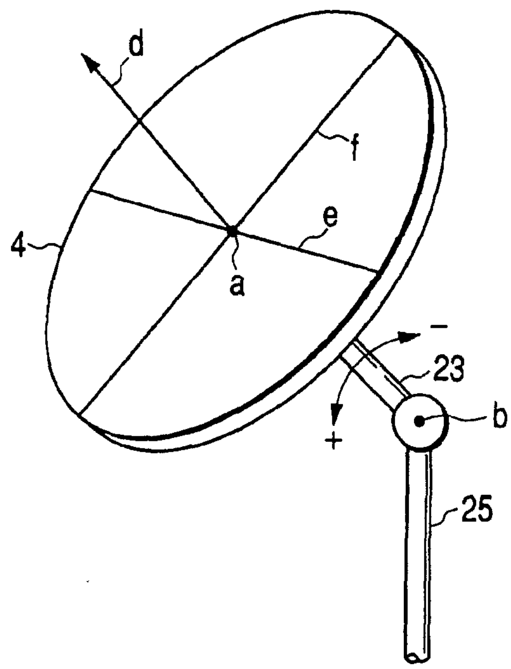


FIG. 6

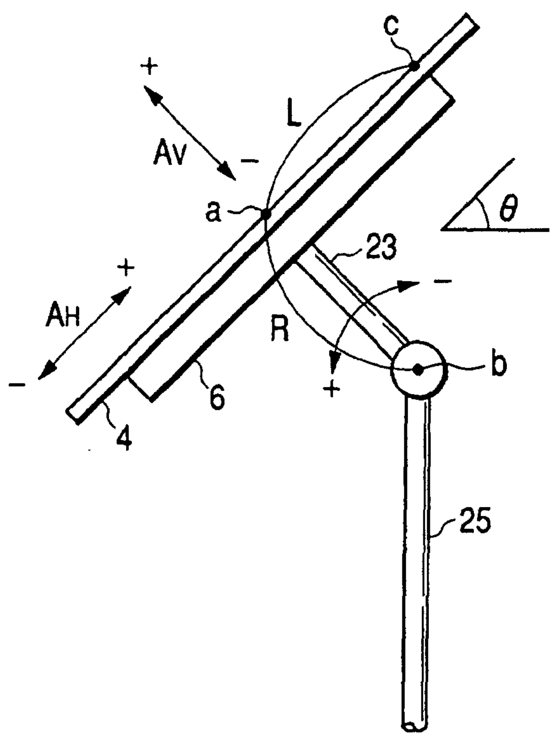

FIG. 7

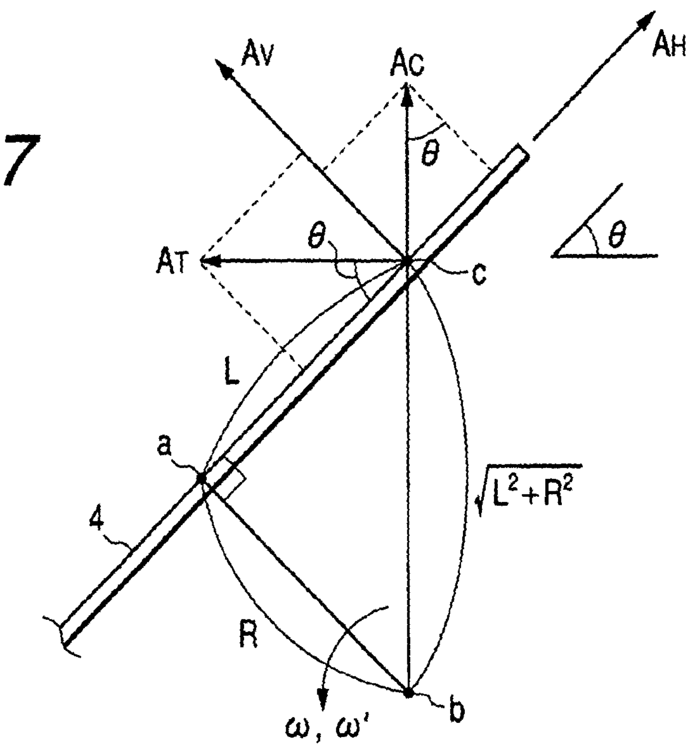


FIG. 8

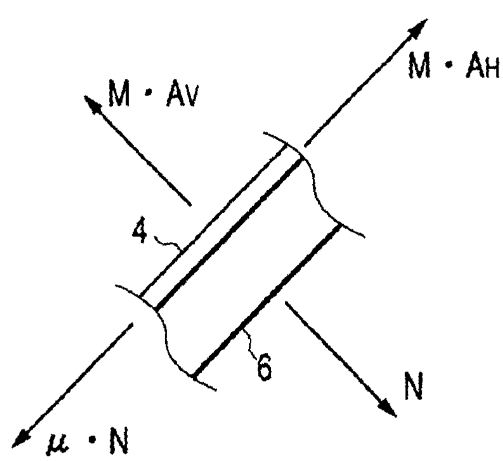

FIG. 9

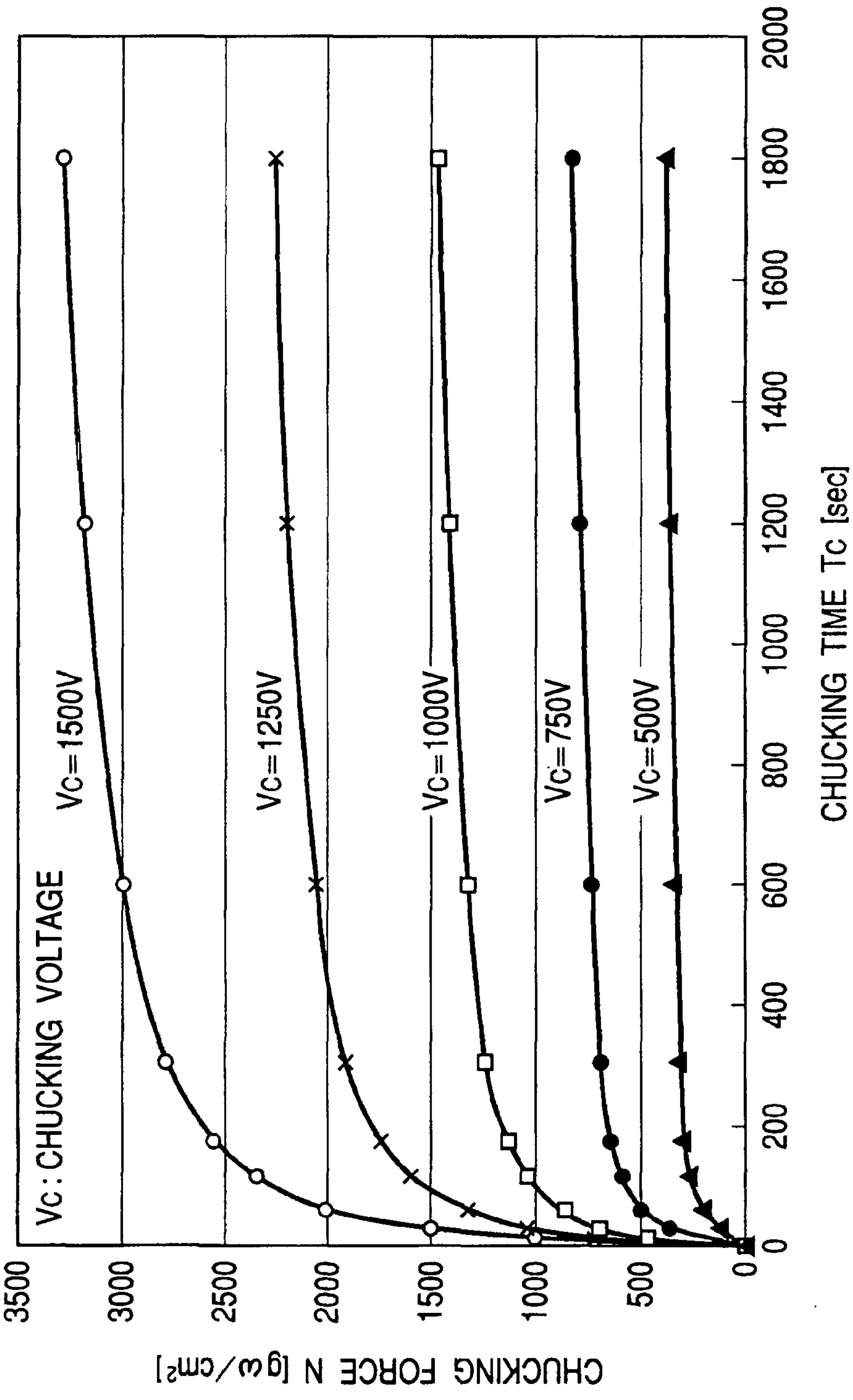
Vc : CHUCKING VOLTAGE
Vc=1500V
Vc=1250V
Vc=1000V
Vc=750V
Vc=500V
CHUCKING FORCE N [gω/cm²]
CHUCKING TIME Tc [sec]
0
500
1000
1500
2000
2500
3000
3500
0
200
400
600
800
1000
1200
1400
1600
1800
2000

FIG. 10

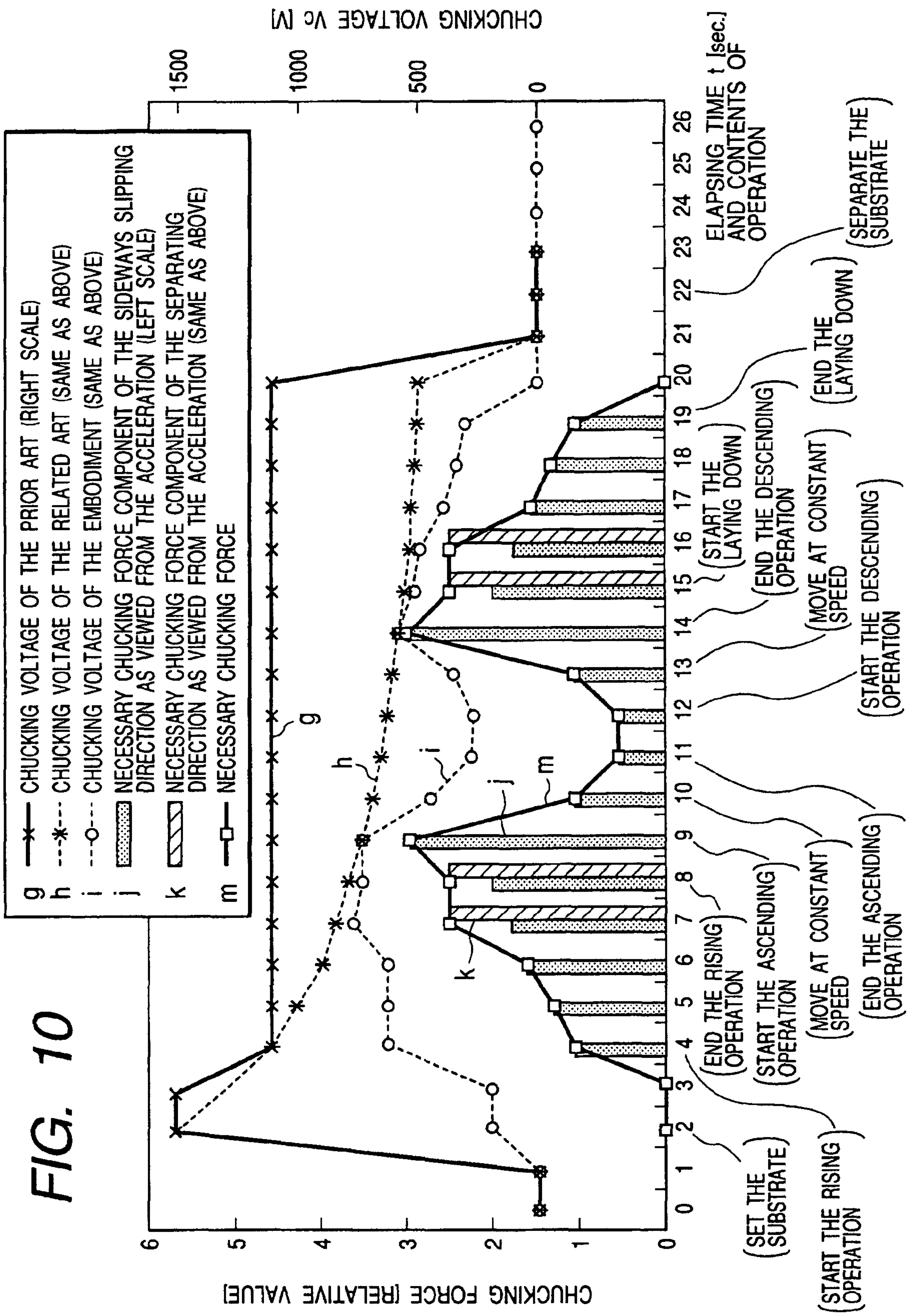
g CHUCKING VOLTAGE OF THE PRIOR ART (RIGHT SCALE)
h CHUCKING VOLTAGE OF THE RELATED ART (SAME AS ABOVE)
i CHUCKING VOLTAGE OF THE EMBODIMENT (SAME AS ABOVE)
j NECESSARY CHUCKING FORCE COMPONENT OF THE SIDEWAYS SLIPPING DIRECTION AS VIEWED FROM THE ACCELERATION (LEFT SCALE)
k NECESSARY CHUCKING FORCE COMPONENT OF THE SEPARATING DIRECTION AS VIEWED FROM THE ACCELERATION (SAME AS ABOVE)
m NECESSARY CHUCKING FORCE
CHUCKING FORCE [RELATIVE VALUE]
CHUCKING VOLTAGE Vc [V]
ELAPSING TIME t [sec.] AND CONTENTS OF OPERATION
(SET THE SUBSTRATE)
(START THE RISING OPERATION)
(END THE RISING OPERATION)
(START THE ASCENDING OPERATION)
(MOVE AT CONSTANT SPEED)
(END THE ASCENDING OPERATION)
(START THE DESCENDING OPERATION)
(MOVE AT CONSTANT SPEED)
(END THE DESCENDING OPERATION)
(START THE LAYING DOWN)
(END THE LAYING DOWN)
(SEPARATE THE SUBSTRATE)

# FIG. 11

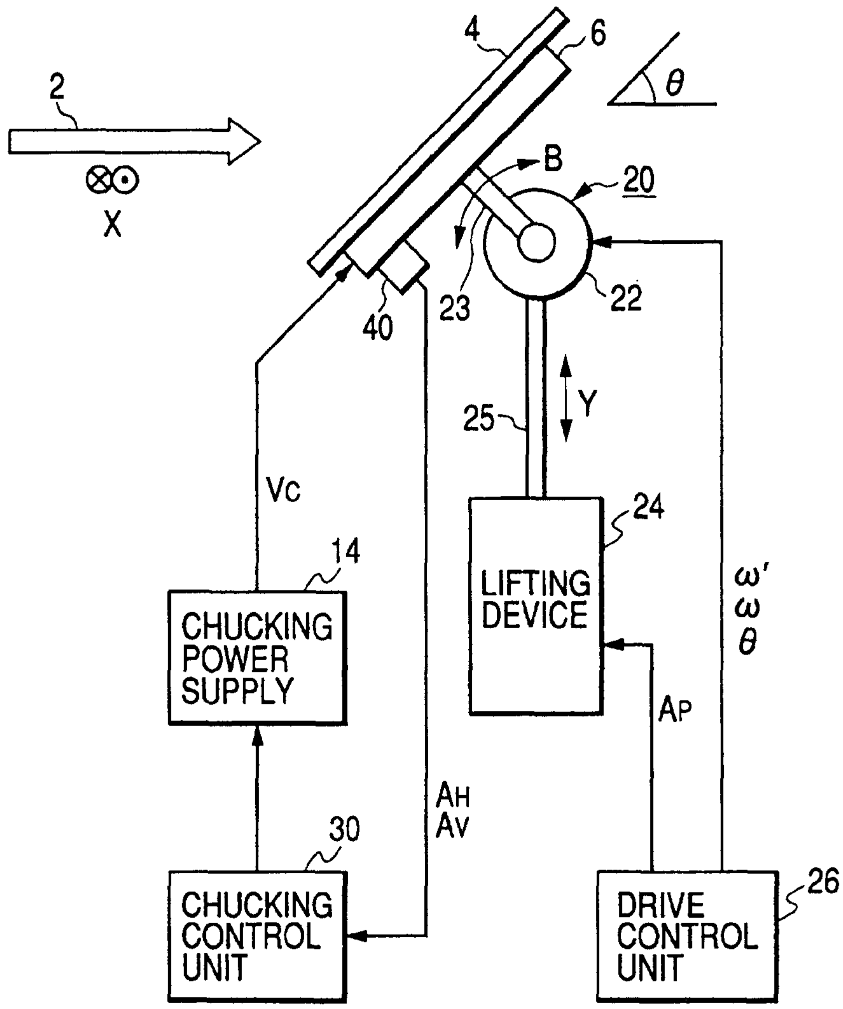
2
X
4
6
θ
B
20
23
22
40
25
Y
VC
24
14
LIFTING DEVICE
CHUCKING POWER SUPPLY
ω'
ω
θ
AP
AH
AV
30
26
CHUCKING CONTROL UNIT
DRIVE CONTROL UNIT

FIG. 12

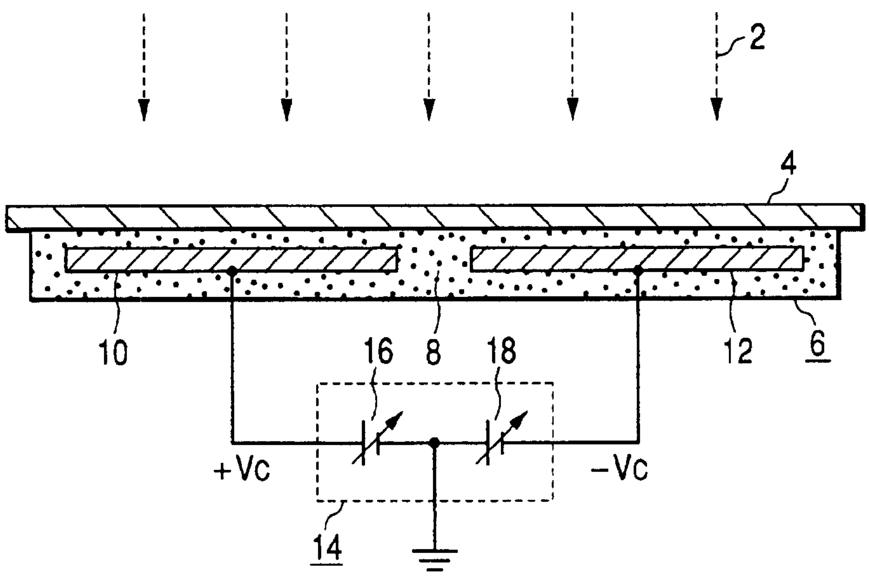

FIG. 13

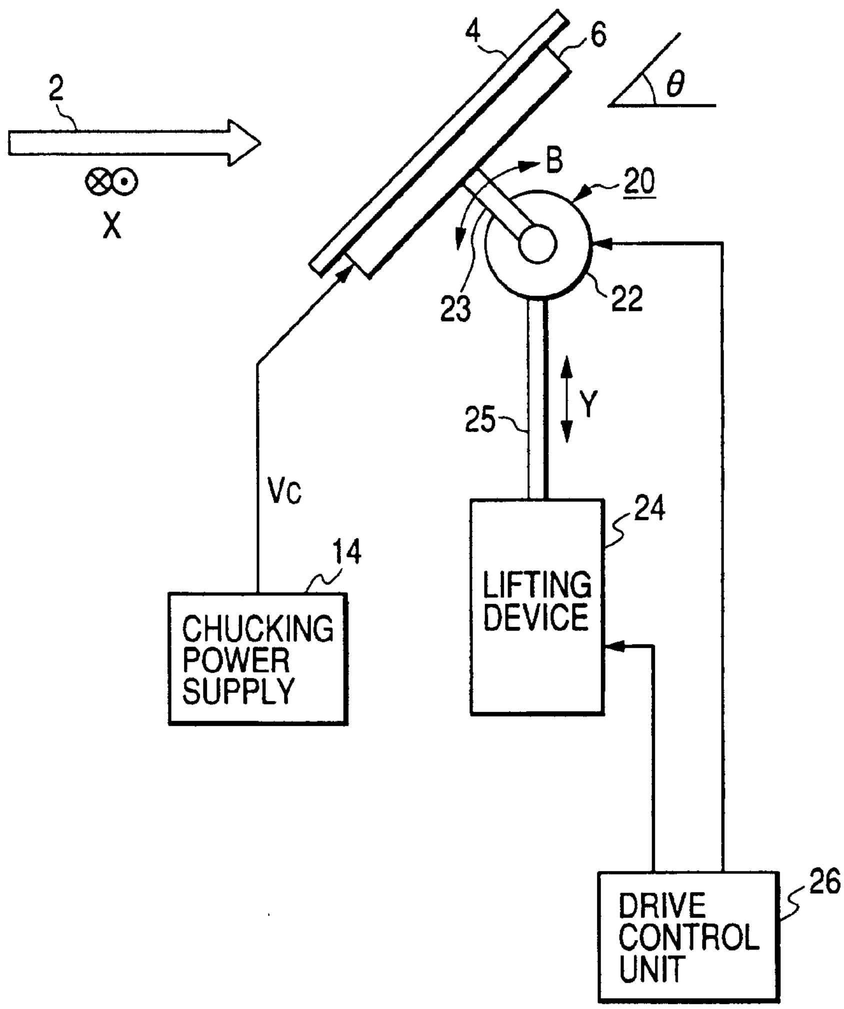
4
6
θ
2
X
B
20
23
22
25
Y
Vc
24
14
CHUCKING POWER SUPPLY
LIFTING DEVICE
DRIVE CONTROL UNIT
26

European Patent Office

# EUROPEAN SEARCH REPORT

Application Number
EP 02 02 1664

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 047 126 A (APPLIED MATERIALS INC) 25 October 2000 (2000-10-25)<br>* figure 1 *<br>* paragraph [0009] *<br>* column 3, line 19 - line 21 *<br>* column 4, line 47 - line 51 *<br>* paragraph [0020] *<br>* paragraph [0023] *<br>--- | 1-8 | H01L21/68 |
| X | WO 99 52144 A (APPLIED MATERIALS INC) 14 October 1999 (1999-10-14)<br>* claim 1 *<br>* figure 1 *<br>* abstract *<br>* page 3, line 19 - line 21 *<br>* page 5, line 12 - line 17 *<br>----- | 1-8 | |
| | | | TECHNICAL FIELDS SEARCHED (Int.Cl.7) |
| | | | H01L |

The present search report has been drawn up for all claims

| Place of search | Date of completion of the search | Examiner |
|---|---|---|
| MUNICH | 9 December 2002 | Bader, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT ON EUROPEAN PATENT APPLICATION NO.** EP 02 02 1664

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2002

| Patent document cited in search report | | Publication date | Patent family member(s) | | Publication date |
|---|---|---|---|---|---|
| EP 1047126 | A | 25-10-2000 | US | 2002008954 A1 | 24-01-2002 |
| | | | EP | 1047126 A2 | 25-10-2000 |
| WO 9952144 | A | 14-10-1999 | US | 6198616 B1 | 06-03-2001 |
| | | | JP | 2002510879 T | 09-04-2002 |
| | | | WO | 9952144 A1 | 14-10-1999 |
| | | | US | 6304424 B1 | 16-10-2001 |

EPO FORM P0459

For more details about this annex : see Official Journal of the European Patent Office, No. 12/82